# EUROPÄISCHE PATENTSCHRIFT

(11) **EP 0 833 167 B1**
(45) Veröffentlichungstag und Bekanntmachung des Hinweises auf die Patenterteilung: **27.07.2005**
(21) Anmeldenummer: 97116780.4
(22) Anmeldetag: 24.09.1997
(51) Int. Cl.: G01R 35/00

(54) **Anordnung zum Kalibrieren eines Netzwerkanalysators für die On-Wafer-Messung an integrierten Mikrowellenschaltungen**
Device for calibrating a network analyser for on-wafer measurement of an integrated microwave circuit
Appareil d'étalonnage d'un analyseur de réseau pour la mesure sur la plaquette d'un circuit intégré micro-ondes

(30) Priorität: 26.09.1996 DE 19639515
(43) Veröffentlichungstag der Anmeldung: 01.04.1998
(73) Patentinhaber: Rosenberger Hochfrequenztechnik GmbH & Co., 84526 Tittmoning (DE)
(72) Erfinder: Heuermann, Holger, Dr. Ing., 84529 Tittmoning (DE)
(74) Vertreter: Graf, Walter, Dipl.-Ing.

(56) Entgegenhaltungen:
- DE-A- 4 313 705
- DE-A- 4 433 375
- US-A- 4 980 636
- US-A- 4 982 164
- US-A- 5 539 305

## Beschreibung

Die Erfindung betrifft eine Anordnung zum Kalibrieren eines Netzwerkanalysators für die On-Wafer-Messung an integrierten Mikrowellenschaltungen auf einer metallischen Grundplatte einer Wafer-Meßeinrichtung mittels in koplanarer Leitungstechnik auf einem Kalibriersubstrat ausgebildeten Kalibrierstandards.

Bei der Herstellung von integrierten Mikrowellenschaltungen auf Halbleiterscheiben (Wafer) müssen die Schaltungen oftmals noch vor der Zerteilung des Wafers elektrisch vermessen werden (On-Wafer-Messung). Dazu sind spezielle Wafer-Meßeinrichtungen (Wafer-Prober) bekannt, die eine metallische Grundplatte (Chuck) aufweisen, in der über die Oberfläche verteilt Ansaugöffnungen ausgebildet sind, die mit einer Unterdruckeinrichtung verbunden sind. Der Wafer wird auf dieser ebenen Grundplatte durch Unterdruck gehalten. Oberhalb der Grundplatte sind Halter für Meßspitzen vorgesehen, durch genaues Verschieben der Grundplatte in X-, Y- und Z-Richtung können so ausgewählte Meßpunkte auf dem aufgespannten Wafer angesteuert und kontaktiert werden (siehe beispielsweise Datenblatt zu Wafer-Prober PA200HF bzw. PM5HF der Firma Süß bzw. Meßspitzen nach US-PS 4 871 964).

Für solche On-Wafer-Messungen an Mikrowellenschaltungen werden vektorielle Netzwerkanalysatoren benutzt, bei denen vor einer Messung eine sogenannte Systemfehlerkorrektur erforderlich ist. Hierbei werden nach bekannten Kalibrierverfahren an mehreren Kalibrierstandards, deren elektrische Kenngrößen ganz oder teilweise bekannt sind, Kalibriermessungen durchgeführt, aus denen über spezielle Rechenverfahren Korrekturdaten gewonnen werden, die anschließend bei der eigentlichen Objektmessung zur Fehlerkorrektur berücksichtigt werden (beispielsweise nach US-PS 4 982 164).

Zur Kalibrierung solcher Netzwerkanalysatoren für die On-Wafer-Messung haben sich Kalibrierstandards als zweckmäßig erwiesen, die in koplanarer Leitungstechnik, z.B. als Koplanarleitung, koplanare Zweibandleitung oder unsymmetrische Koplanarleitung auf einem Kalibriersubstrat ausgebildet sind (koplanare Streifenleitungen beispielsweise nach Zinke/Brunswick, Hochfrequenztechnik 1, 5. Auflage, S. 157 bzw. 169 - 176). Koplanare Streifenleitungen sind dispersionsarm und besitzen über eine große Bandbreite eine geringe Änderung des Wellenwiderstandes sowie eine geringe Frequenzabhängigkeit der elektrischen Länge. Solche Kalibrierstandards in koplanarer Streifenleitungstechnik werden beispielsweise auf einem Substrat aus Saphir oder Aluminiumoxyd in Dünnschichttechnik hergestellt. Ein für solche Zwecke besonders geeigneter Kalibrierstandard, wie er beispielsweise von der Firma Rosenberger angeboten wird (Kalibriersubstrat RCPW-LMR in Produktschrift TI 020/18.04.96/E1.0) benutzt zwei auf einem Kalibriersubstrat ausgebildete kurze koplanare Streifenleitungsabschnitte (LL) mit bekanntem Wellenwiderstand und zwei Kurzschlußbalken (R). Vor der eigentlichen On-Wafer-Objektmessung wird dieses Kalibriersubstrat auf der Grundplatte der Wafer-Meßeinrichtung aufgesetzt und mittels der Meßspitzen, die mit dem Netzwerkanalysator verbunden sind, werden die erwähnten Kalibriermessungen z.B. nach dem LLR-Verfahren an den Kalibrierstandards L, L und R nacheinander durchgeführt.

Bei auf Halbleitersubstraten (Wafer) ausgebildeten Mikrowellenschaltungen hat nur ein geringer Teil der Substratdicke (ca. 500µm) bis zu einer Tiefe von ca. 10µm Einfluß auf das elektrische Verhalten der Schaltung. Die Meßergebnisse bei der On-Wafer-Messung werden daher bei der eigentlichen Objektmessung durch die metallische Grundplatte nicht beeinträchtigt. Es hat sich jedoch gezeigt, daß bei der Kalibriermessung vor allem bei höheren Frequenzen im GHz-Bereich beim Vermessen der in koplanarer Leitungstechnik ausgebildeten Kalibrierstandards erhebliche Meßfehler und in Folge davon bei der Objektmessung Korrekturfehler auftreten.

Zur praktischen Untersuchung dieser Meß- und KorrekturFehler ist es bekannt, das die Kalibrierstandards tragende Kalibriersubstrat auf einem Abstandhalter aus Quarz von 2 mm oder mehr Dicke anzuordnen (Williams, Dylan et al. "Progress Towards MMIC On-Wafer Standards", 36^{th} ARFTG Conference Digest, published February 1991, and reporting the papers presented at the 36^{th} ARFTG Conference helt November 29-30, 1990 at the Monterrey Sheraton, Monterrey, California, USA). Vergleichsmessungen mit Kalibrierstandards, deren Kalibriersubstrat unmittelbar auf der Grundplatte aufliegt, haben jedoch keine nennenswerte Verbesserung der Meßfehler durch diese Quarzunterlage ergeben.

Es ist Aufgabe der Erfindung, eine Kalibrieranordnung der eingangs bezeichneten Art zu schaffen, bei der solche Meßfehler während der Kalibrierung vermieden werden.

Diese Aufgabe wird ausgehend von einer Anordnung laut Oberbegriff des Hauptanspruches durch dessen kennzeichnende Merkmale gelöst. Vorteilhafte Weiterbildungen ergeben sich aus den Unteransprüchen.

Die Erfindung geht aus von der Erkenntnis, daß die erwähnten Meßfehler bei der Kalibrierung mit koplanaren Kalibrierstandards auf den Einfluß der metallischen Grundplatte der Wafer-Meßeinrichtung zurückzuführen sind. Aufgrund der unterhalb des Kalibriersubstrats vorhandenen metallischen Grundplatte kann sich kein reiner und gut berechenbarer koplanarer Feldtyp ausbilden. Untersuchungen haben gezeigt, daß insbesondere bei höheren Frequenzen sich längs der koplanaren Leitungen der Kalibrierstandards ein dominierender Mikrostreifenleitungsfeldtyp ausbildet. Durch die metallische Grundplatte wird also das elektromagnetische Feld der koplanaren Kalibrierstandards nicht nur beeinträchtigt, sondern sogar von einer Feldverteilung einer Koplanarleitung zu einer Feldverteilung einer Mikrostreifenleitung verändert. Die Feldtypen bzw. Wellenarten einer Koplanarleitung und einer Mikrostreifenleitung unterscheiden sich nicht nur im Feldbild, sondern sie bedingen auch einen unterschiedlich großen Wellenwiderstand und unterschiedliche elektrische Längen der Leitungen. Durch die Veränderung des Feldtypes werden daher zu höheren Frequenzen auch diese elektrischen Kenngrößen erheblich geändert, worauf die erwähnten Meßfehler zurückzuführen sind.

Diese Wirkung wird durch die erfindungsgemäße Maßnahme vermieden. Durch die Luftkammer unterhalb der Kalibrierstandards kann sich auch während der Kalibrierung ein reiner und unverfälschter koplanarer Feldtyp längs der Kalibrierstandards ausbilden und es wird ein Mikrostreifenleitungsfeldtyp mit großer Frequenzabhängigkeit (Dispersion) vermieden. Außerdem werden auch die Einflüsse der Vakuumbohrungen in der metallischen Grundplatte der Wafer-Meßeinrichtung auf die Kalibrierstandards vermieden. Die in Vergleich zu den Kalibrierstandards relativ großen Vakuumbohrungen verändern bei unmittelbar auf der Grundplatte aufgesetzten Kalibrierstandards das elektrische Leitungsverhalten der Kalibrierstandards und auch hierauf zurückzuführende Meßfehler werden daher durch die unterhalb der Kalibrierstandards vorgesehenen Luftkammer vermieden. Wenn sich zwischen Kalibriersubstrat und Grundplatte nur Luft, im Idealfall ein Vakuum, befindet, können die Kalibrierstandards sehr genau berechnet und hergestellt werden, da keine Beeinträchtigung durch andere dielektrische Materialien auftritt, sofern auch ein genügen großer seitlicher Abstand zwischen den in koplanarer Leitungstechnik ausgebildeten Kalibrierstandards und den Rändern der Luftkammer besteht.

Die Erfindung wird im folgenden anhand von zwei Ausführungsbeispielen näher erläutert.

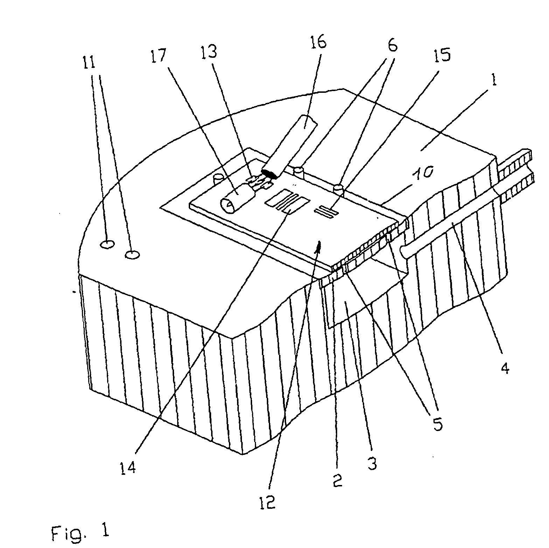

Fig. 1 zeigt in stark vergrößertem Maßstab den Teilabschnitt einer metallischen Grundplatte 1 einer Wafer-Meßeinrichtung und zwar teilweise im Schnitt. In der Oberfläche der Grundplatte (Chuck) ist von oben eine Kammer 3 ausgefräst, die eine umlaufende Randnut 10 aufweist, in welcher eine Abdeckplatte 2 aus dielektrischem Material eingesetzt ist. Die Luftkammer 3 ist außerhalb des Bereiches, in dem normalerweise der nicht dargestellte Wafer aufgespannt ist, ausgebildet, im Randbereich der Grundplatte 1 können gegebenenfalls auch mehrere solche Kammern 3 zur Aufnahme von Kalibrierstandards ausgebildet sein. Das Material der Abdeckplatte 2 besitzt vorzugsweise die gleichen dielektrischen Eigenschaften wie das Kalibriersubstrat 12. Das Innere der Kammer 3 ist über einen Kanal 4 mit der nicht dargestellten Vakuumpumpe der Wafer-Meßeinrichtung verbunden. Auch die über die Oberfläche der Grundplatte 1 verteilten Vakuumbohrungen 11 zum Halten des Wafers bei der On-Wafer-Messung sind mit dieser Vakuumpumpe verbunden. In der Abdeckplatte 2 sind ebenfalls Vakuumbohrungen 5 ausgebildet, über die ein auf der Oberseite der Abdeckplatte 2 aufgelegtes Kalibriersubstrat 12 durch Unterdruck gehalten wird. Auf dem Kalibriersubstrat 12 mit einer Dicke von beispielsweise 635 um sind beispielsweise in Dünnschichttechnik nebeneinander zwei L-(Leitungs-)Kalibrierstandards 13 und 14 in Koplanarleitungstechnik ausgebildet, sie bestehen jeweils aus drei in bekannter Weise bezüglich Breite und Abstand dimensionierten Streifen vorbestimmter Länge. Ein dritter R-(Reflektion-)Kalibrierstandard 15 wird durch zwei nebeneinanderliegende Streifen gebildet. Über schematisch angedeutete Meßspitzen 16, 17, die oberhalb der Grundplatte an der Wafer-Meßeinrichtung gehalten sind und die mit dem nicht dargestellten Netzwerkanalysator in Verbindung stehen, werden bei der Kalibrierung die Streifen der Kalibrierstandards kontaktiert. Die Vakuumbohrungen 5 in der Abdeckplatte 2 sind so verteilt, daß sie jeweils außerhalb der Kalibrierstandards liegen und daher die koplanaren Leitungen nicht störend beeinflussen. Um die exakte geometrische Lage des Kalibriersubstrats 12 auf der Abdeckplatte 2 zu gewährleisten sind noch zusätzliche Paßstifte 6 vorgesehen, die vorzugsweise in der Spannplatte 1 am Rand der Luftkammer eingesetzt sind.

Eine andere Möglichkeit besteht darin, die Abmessungen der Luftkammer 3 kleiner zu wählen als die Längs- und Querabmessungen des Kalibriersubstrats 12, so daß das Kalibriersubstrat 12 ohne Zwischenlage einer Abdeckplatte 2 unmittelbar am Rand der Luftkammer 3 aufliegt und durch Vakuum gehalten wird.

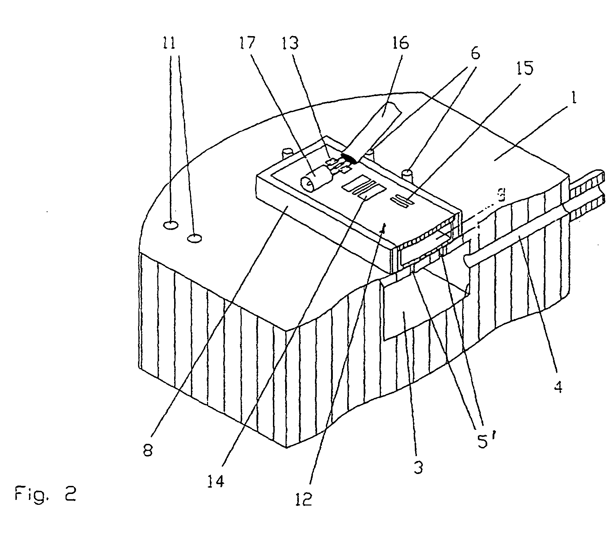

Fig. 2 zeigt eine weitere Möglichkeit für die Anbringung der Kalibrierstandards im Abstand von der metallischen Grundplatte 1. In diesem Ausführungsbeispiel kann die Grundplatte einer üblichen Wafer-Meßeinrichtung unverändert bleiben. Die Kalibriereinrichtung wird in diesem Ausführungsbeispiel als gesondertes Bauelement auf die Oberfläche der Grundplatte 1 aufgesetzt und durch die in der Grundplatte zum Halten des Wafers vorgesehenen Vakuumbohrungen 11 gehalten. Zur groben Positionierung der Kalibriereinrichtung vorzugsweise an einer oder mehreren Stellen im Randbereich der Grundplatte sind wieder Paßstifte 6 vorgesehen. Das Kalibriersubstrat 12 mit den wieder in koplanarer Leitungstechnik ausgebildeten Kalibrierstandards 13, 14, 15 ist als Deckel eines kleinen flachen kastenartigen Gehäuses 8 ausgebildet, vorzugsweise wieder in einer umlaufenden Ringnut am Rand des Kastengehäuses eingesetzt und auf geeignete Weise am Gehäuse befestigt. Das Gehäuse 8 besteht entweder aus dielektrischem Material, vorzugweise jedoch aus Metall, da hiermit die Kalibrierstandards präzise definiert, berechnet und hergestellt werden können. Der flache geschlossene Boden des Kastengehäuses 8 wird über die Vakuumbohrungen 5 auf der Oberfläche der Grundplatte 1 gehalten, im Inneren des Kastengehäuses 8 ist zwischen Gehäuseboden und Kalibriersubstrat 12 eine Luftkammer 9 ausgebildet.

Eine weitere Möglichkeit besteht darin, im Boden des Kastengehäuses 8 eine mit einer der Vakuumbohrungen 5' fluchtende Öffnung vorzusehen, so daß auch in der Luftkammer 9 ein Vakuum entsteht. In diesem Fall kann dann das Kalibriersubstrat 12 ebenfalls durch Unterdruck am Rand des Kastenhäuses 8 gehalten werden und leicht gegen andere Kalibrierstandards ausgewechselt werden.

Der Abstand zwischen Kalibriersubstrat und metallischer Grundplatte zur Vermeidung eines Umwandelns des koplanaren Feldtyps in einen Mikrostreifenleitungsfeldtyp hängt von der Art der verwendeten Koplanarleitungen und auch von der Dicke und dem Material des Kalibriersubstrats ab, im allgemeinen genügt es, diesen Abstand etwa 2 mm zu wählen. In der Luftkammer 3 bzw. 9 kann gegebenenfalls auch ein Absorbermaterial eingeordnet sein das störende Effekte wie beispielsweise elektrische Hohlraumresonanzen vermeidet.

## Patentansprüche

1. Anordnung zum Kalibrieren eines Netzwerkanalysators für die On-Wafer-Messung an Mikrowellenschaltungen auf einer metallischen Grundplatte (1) einer Wafer-Meßeinrichtung mittels in koplanarer Leitungstechnik auf einem Kalibriersubstrat (12) ausgebildeten Kalibrierstandards (13, 14, 15), wobei das Kalibriersubstrat (12) im Abstand oberhalb der metallischen Grundplatte (1) angeordnet ist,
**dadurch gekennzeichnet,**
**daß** zwischen Kalibriersubstrat (12) und metallischer Grundplatte (1) eine Luftkammer (3, 9) vorgesehen ist und daß die Luftkammer (3) in der Oberseite der Grundplatte (1) ausgebildet ist und das Kalibriersubstrat (12) oberhalb dieser Luftkammer (3) angeordnet ist.

2. Anordnung nach Anspruch 1 für eine Wafer-Meßeinrichtung mit Unterdruckeinrichtung zum Halten des Wafers auf der Grundplattenoberfläche,
**dadurch gekennzeichnet,**
**daß** die Luftkammer (3) mit einer Unterdruckeinrichtung verbunden ist.

3. Anordnung nach Anspruch 2,
**dadurch gekennzeichnet,**
**daß** die Luftkammer (3) mit einer Abdeckplatte (2) aus dielektrischem Material abgedeckt ist und das Kalibriersubstrat (12) auf der Oberseite dieser Abdeckplatte (2) angeordnet ist.

4. Anordnung nach Anspruch 3,
**dadurch gekennzeichnet,**
**daß** in der Abdeckplatte (2) Ansaugöffnungen (5) zum Halten des Kalibriersubstrats (12) ausgebildet sind.

5. Anordnung nach Anspruch 3 oder 4,
**dadurch gekennzeichnet,**
**daß** die Abdeckplatte (2) in einer die Luftkammer (3) umgebenden Randnut (10) versenkt und mit der Oberfläche der Grundplatte (1) fluchtend angeordnet ist.

6. Anordnung nach Anspruch 3 bis 5,
**dadurch gekennzeichnet,**
**daß** die Abdeckplatte (2) aus einem dielektrischen Material mit den gleichen dielektrischen Eigenschaften wie das Kalibriersubstrat (12) ausgebildet ist.

7. Anordnung nach einem der Ansprüche 3 bis 6,
**dadurch gekennzeichnet,**
**daß** die in der Abdeckplatte (2) ausgebildeten Ansaugöffnungen (5) in Bereichen vorgesehen sind, in denen bei aufgelegtem Kalibriersubstrat (12) keine Kalibrierstandards (13, 14, 15) vorhanden sind.

8. Anordnung nach Anspruch 2,
**dadurch gekennzeichnet,**
**daß** die Längs- und Querabmessungen der Luftkammer (3) kleiner als die des Kalibriersubstrats (12) gewählt sind und das Kalibriersubstrat (12) unmittelbar durch Unterdruck am Rand der Luftkammer (3) gehalten ist.

9. Anordnung nach einem der Ansprüche 1, 2 oder 3,
**dadurch gekennzeichnet,**
**daß** das Kalibriersubstrat (12) auf der Oberseite eines flachen oben offenen Kastengehäuses (8) angeordnet ist, das mit seinem Boden auf der Oberfläche der Grundplatte (1) aufsetzbar ist (Fig. 2).

10. Anordnung nach Anspruch 9,
**dadurch gekennzeichnet,**
**daß** das Kalibriersubstrat (12) den Deckel des Kastengehäuses (8) oberhalb einer Luftkammer (9) bildet.

11. Anordnung nach Anspruch 9 oder 10,
**dadurch gekennzeichnet,**
**daß** das Kastengehäuse (8) durch Unterdruck auf der Oberfläche der Grundplatte (1) gehalten ist.

12. Anordnung nach Anspruch 9, 10 oder 11,
**dadurch gekennzeichnet,**
**daß** im Boden des Kastengehäuses (8) mindestens eine mit der Unterdruckeinrichtung verbindbare Öffnung ausgebildet ist und das Kalibriersubstrat (12) ebenfalls durch Unterdruck am Kastengehäuse (8) gehalten ist.

13. Anordnung nach einem der Ansprüche 9 bis 12,
**dadurch gekennzeichnet,**
**daß** das Kastengehäuse (8) auf der Oberseite mit einer Ansaugöffnungen aufweisenden Abdeckplatte aus dielektrischen Material verschlossen ist und das Kalibriersubstrat (12) auf dieser Abdeckplatte aufliegt.

## Claims

1. Arrangement for calibrating a network analyser for on-wafer testing of microwave circuits on a metallic base plate (1) of a wafer-testing device by means of calibration standards (13, 14, 15) formed using coplanar-line technology on a calibration substrate (12), wherein the calibration substrate (12) is arranged at a distance above the metallic base plate (1),
**characterised in that**
an air chamber (3, 9) is provided between the calibration substrate (12) and the metallic base plate (1), and that the air chamber (3) is formed in the upper side of the base plate (1), the calibration substrate (12) being arranged above this air chamber (3).

2. Arrangement according to claim 1 for a wafer-testing device with a vacuum-pressure device for holding the wafer on the surface of the base plate,
**characterised in that**
the air chamber (3) is connected to a vacuum-pressure device.

3. Arrangement according to claim 2,
**characterised in that**
the air chamber (3) is covered with a covering plate (2) made from dielectric material, and the calibration substrate (12) is arranged on the upper side of this covering plate (2).

4. Arrangement according to claim 3,
**characterised in that**
suction openings (5) for holding the calibration substrate (12) are formed in the covering plate (2).

5. Arrangement according to claim 3 or 4,
**characterised in that**
the covering plate (2) is countersunk in a peripheral groove (10) surrounding the air chamber (3) and arranged to be flush with the surface of the base plate (1).

6. Arrangement according to claim 3 to 5,
**characterised in that**
the covering plate (2) is formed from a dielectric material with the same dielectric properties as the calibration substrate (12).

7. Arrangement according to any one of claims 3 to 6,
**characterised in that**
the suction openings (5) formed in the covering plate (2) are disposed in regions, in which no calibration standards (13, 14, 15) are present when the calibration substrate (12) is in position.

8. Arrangement according to claim 2,
**characterised in that**
the longitudinal and transverse measurements of the air chamber (3) are selected to be smaller than those of the calibration substrate (12), and that the calibration substrate (12) is held on the edge of the air chamber (3) directly by vacuum pressure.

9. Arrangement according to any one of claims 1, 2 or 3,
**characterised in that**
the calibration substrate (12) is arranged on the upper side of a flat box housing (8), which is open at the top and can be placed with its base on the surface of the base plate (1) (Figure 2).

10. Arrangement according to claim 9,
**characterised in that**
the calibration substrate (12) forms the cover of the box housing (8) above an air chamber (9).

11. Arrangement according to claim 9 or 10,
**characterised in that**
the box housing (8) is held by vacuum pressure on the surface of the base plate (1).

12. Arrangement according to claim 9, 10 or 11,
**characterised in that**
at least one opening, which can be connected to the vacuum-pressure device, is formed in the base of the box housing (8), and that the calibration substrate (12) is also held on the box housing (8) by vacuum pressure.

13. Arrangement according to any one of claims 9 to 12,
**characterised in that**
the upper side of the box housing (8) is closed with a covering plate made from dielectric material and providing suction openings, and that the calibration substrate (12) is positioned on this covering plate.

## Revendications

1. Dispositif pour l'étalonnage d'un analyseur de réseau pour la mesure sur la plaquette (On-Wafer) de circuits intégrés pour micro-ondes sur une platine de base métallique (1) d'un dispositif de mesure sur plaquette à l'aide d'un étalon type (13, 14, 15) formé sur un substrat d'étalonnage (12) suivant la technique de ligne coplanaire, le substrat d'étalonnage (12) étant disposé à distance au-dessus de la platine de base métallique (1),
**caractérisé en ce qu'**une chambre d'air (3, 9) est prévue entre le substrat d'étalonnage (12) et la platine de base métallique (1) et **en ce que** la chambre d'air (3) est formée sur la face supérieure de la platine de base (1) et le substrat d'étalonnage (12) est placé au-dessus de cette chambre d'air (3).

2. Dispositif selon la revendication 1 pour un dispositif de mesure de plaquette avec un dispositif à dépression pour maintenir la plaquette sur la surface de la platine de base,
**caractérisé en ce que** la chambre à air (3) est reliée à un dispositif à dépression.

3. Dispositif selon la revendication 2,
**caractérisé en ce que** la chambre à air (3) est recouverte par une platine de recouvrement (2) faite d'un matériau diélectrique et le substrat d'étalonnage (12) est placé sur la face supérieure de cette platine de recouvrement (2).

4. Dispositif selon la revendication 3,
**caractérisé en ce que** des ouvertures d'aspiration (5) sont formées dans la platine de recouvrement (2) pour maintenir le substrat d'étalonnage (12).

5. Dispositif selon la revendication 3 ou 4,
**caractérisé en ce que** la platine de recouvrement (2) est enfoncée dans une rainure marginale (10) entourant la chambre à air (3) et est alignée avec la surface de la platine de base (1).

6. Dispositif selon les revendications 3 à 5,
**caractérisé en ce que** la platine de recouvrement (2) est faite d'un matériau diélectrique ayant les mêmes propriétés diélectriques que le substrat d'étalonnage (12).

7. Dispositif selon l'une quelconque des revendications 3 à 6,
**caractérisé en ce que** les ouvertures d'aspiration (5) formées dans la platine de recouvrement (2) sont prévues dans des zones dans lesquelles aucun étalon type (13, 14, 15) n'est présent lorsque le substrat d'étalonnage (12) est posé.

8. Dispositif selon la revendication 2,
**caractérisé en ce que** les dimensions longitudinales et transversales de la chambre à air (3) sont choisies pour être plus petites que celles du substrat d'étalonnage (12) et le substrat d'étalonnage (12) est maintenu sur le bord de la chambre à air (3) directement par la dépression.

9. Dispositif selon l'une quelconque des revendications 1, 2 ou 3,
**caractérisé en ce que** le substrat d'étalonnage (12) est placé sur la face supérieure d'un boîtier fermé (8) plat ouvert en haut dont le fond peut être posé (voir figure 2) sur la surface de la platine de base (1)

10. Dispositif selon la revendication 9,
**caractérisé en ce que** le substrat d'étalonnage (12) forme le couvercle du boîtier fermé (8) au-dessus d'une chambre à air (9).

11. Dispositif selon la revendication 9 ou 10,
**caractérisé en ce que** le boîtier fermé (8) est maintenu par dépression sur la surface de la platine de base (1).

12. Dispositif selon la revendication 9, 10 ou 11,
**caractérisé en ce qu'**au moins une ouverture raccordable au dispositif à dépression est formée dans le fond du boîtier fermé (8) et le substrat d'étalonnage (12) est également maintenu par dépression sur le boîtier fermé (8).

13. Dispositif selon l'une quelconque des revendications 9 à 12,
**caractérisé en ce que** le boîtier fermé (8) est obturé sur la face supérieure par une platine de recouvrement comportant des ouvertures d'aspiration faite d'un matériau diélectrique et le substrat d'étalonnage (12) est posé sur cette platine de recouvrement.
